# EUROPEAN PATENT APPLICATION

(11) **EP 2 725 877 A1**
(43) Date of publication of application: **30.04.2014**
(21) Application number: 11868184.0
(22) Date of filing: 24.06.2011
(51) Int. Cl.: H05B 33/22, H01L 51/50, H05B 33/02, H05B 33/10, H05B 33/12

(54) **ORGANIC LIGHT EMITTING ELEMENT AND METHOD FOR MANUFACTURING ORGANIC LIGHT EMITTING ELEMENT**

(71) Applicant: Showa Denko K.K., Tokyo 105-8518 (JP)
(72) Inventor: KONDO, Kunio, Tokyo 105-8518 (JP); SAKO, Kanjiro, Tokyo 105-8518 (JP); TAJIMA, Masaru, Tokyo 105-8518 (JP); HIROSE, Katsumasa, Tokyo 105-8518 (JP)
(74) Representative: Strehl Schübel-Hopf & Partner
(86) International application number: PCT/JP2011/064568
(87) International publication number: WO 2012/176335

(57) **Abstract**

An organic light emitting element (10) includes: an anode layer (12) formed on a substrate (11); a first dielectric layer (13) formed on the anode layer (12); a cathode layer (14) formed on the first dielectric layer (13); plural through-hole portions (16) passing through at least the anode layer (12) and the first dielectric layer (13); a second dielectric layer (19) formed in contact with an upper surface of the substrate (11) and a side surface of the anode layer (12); and a light emitting portion (17) formed in contact with the cathode layer (14), the side surface of the anode layer (12) and the upper surface of the second dielectric layer (19). Consequently, the organic light emitting element or the like having high light extraction efficiency and high light emission efficiency is provided.

## Description

### Technical Field

The present invention relates to an organic light emitting element or the like used for, for example, a display device or an illuminating device.

### Background Art

In an organic light emitting element, which has been expected to be applied to a display device or an illumination device in recent years, a pair of electrodes including an anode and a cathode is attached to a light emitting layer in which a light emitting material is formed to be a layer shape and a voltage is applied thereto, holes and electrons are injected from the anode and the cathode respectively, and light is emitted by using an energy generated by coupling the injected electrons and holes.

As an example of such an organic light emitting element, Patent Document 1, for example, suggests a cavity light emitting element that includes a dielectric layer interposed between a hole injection electrode layer and an electron injection electrode layer, and in which a light emitting coating material is applied to an inner surface of a cavity extending through at least the dielectric layer and one of the electrode layers and including a hole injection electrode area, an electron injection electrode area and a dielectric area.

Further, Patent Document 2 discloses an organic light emitting element in which a low refractive index area made of a material having a refractive index lower than that of a substrate is provided to be adjacent to a light emitting region.

Further, Patent Document 3 discloses an electroluminescence device in which are provided a hole injection electrode layer, an electron injection electrode layer, a dielectric layer interposed between the hole injection electrode layer and the electron injection electrode layer, and a cavity extending through at least one of the dielectric layer and either of electrode layers. The cavity has an inner cavity surface provided with a hole injection electrode area, an electron injection electrode area and a dielectric area. An electroluminescence coating material electrically contacts with a hole injection electrode area and an electron injection electrode area of the inner cavity surface.

Further, Patent Document 4 discloses an organic LED element in which an anode electrode that is a transparent electrode, an organic layer, and a cathode electrode are laminated in this order on a transparent substrate in which dielectric membrane is formed, and in the organic LED element, there is a relationship of |n₃-n₂| ≤0.25 and |n₁-n_{2|} ≤0.20 among the refractive index n₁ of the organic layer, the refractive index n₂ of the anode electrode, and the refractive index n₃ of the dielectric membrane in the wavelength range of 450 nm to 650 nm under the condition that the thickness of the dielectric layer is more than 0.5 µm is satisfied.

Further, Patent Document 5 discloses an organic electroluminescence element in which a diffractive grating is provided on a surface layer of a substrate, and thereon an organic EL layer including a light emitting layer between an anode electrode and a cathode electrode is provided through an interlayer.

Further, Patent Document 6 discloses an optical member in which a micro-lens array, a substrate, a structure layer, a planarizing layer, and a first gas barrier layer are laminated in this order, and the first gas barrier layer is a transparent inorganic oxide layer having a wettability index of less than 50 dyn/cm (JIS K 6768).

Further, Patent Document 7 discloses a display device of an active matrix type in which a substrate and a circuit portion formed on the substrate are provided, a pixel area is formed on the circuit portion corresponding to respective TFTs for driving the circuit portion, respective organic EL elements are formed in the pixel area, an anode buffer layer of the organic EL element is formed by changing a polysiloxane derivative into SiO₂ by irradiating a membrane of the polysiloxane derivative obtained by plasma polymerization of a precursor (monomer) with ultraviolet rays.

### Citation List

### Patent Literature

Patent Document 1: Japanese Patent Application Unexamined Publication (Translation of PCT Application) No. 2010-509729
Patent Document 2: U.S. Patent Application Publication No. US 2008/0238310 A1
Patent Document 3: Japanese Patent Application Unexamined Publication (Translation of PCT Application) No. 2003-522371
Patent Document 4: Japanese Patent Application Laid-Open Publication No. 2006-338954
Patent Document 5: Japanese Patent Application Laid-Open Publication No. 2004-349111
Patent Document 6: Japanese Patent Application Laid-Open Publication No. 2008-117735
Patent Document 7: Japanese Patent Application Laid-Open Publication No. 2007-123052

### Disclosure of Invention

### Technical Problem

In general, a cavity light emitting element is easy to increase usage efficiency of light, since light emitted from a light emitting coating material is made to be directly extracted through the cavity. However, the usage efficiency of light is reduced in some cases since reflection is easy to occur depending on an angle of the light reaching a light extraction surface.

Further, as a method for forming a cavity structure, there is a case where an etching is performed for patterning an electrode on a substrate side and a dielectric layer. At this time, the etching process tends to be complicated since the etching conditions of the dielectric layer and the electrode are different from each other in general. Moreover, since the etching condition for the electrode is generally severer than that for the dielectric layer, a resist used as a mask is required to be thick. Therefore, there has been a disadvantage that the time required for resist formation and etching tends to be long. As a result, it was difficult to stably produce an expected shape. Furthermore, there has been a limitation in material selectivity that only material being able to be etched can be used as the dielectric layer.

In addition, in an organic light emitting element in which a low refractive index area is provided in a light emitting area, an electrode layer made of indium tin oxide (hereinafter, referred to as ITO) is located below the low refractive index area. Since the light transmission of the ITO is smaller than that of the low refractive index area, light entering into the electrode layer from the low refractive index area is heavily attenuated in intensity. Furthermore, since ITO has a high refractive index, the light entering into the electrode layer tends to be confined within the electrode layer by total reflection. Therefore, light extraction efficiency is lowered.

An object of the present invention is to provide an organic light emitting element and the like which has high light emitting efficiency by suppressing light emitted from the light emitting layer from being confined in the light emitting element.

### Solution to Problem

To solve the above problem, the present inventors have found that, with an organic light emitting element in which a dielectric layer is sandwiched between a pair of electrodes and a light emitting portion is provided in through-hole portions formed to pass through the electrode and the dielectric layer, more light can be extracted from inside of the light emitting layer or inside of the electrode layer by forming a dielectric layer also inside of the through-hole portion, and completed the invention. That is, the present invention is summarized as below.

An organic light emitting element according to the present invention includes; a first electrode layer that is formed on a substrate; a first dielectric layer that is formed on the first electrode layer; a second electrode layer that is formed on the first dielectric layer; plural through-hole portions that pass through at least the first electrode layer and the first dielectric layer; a second dielectric layer that is formed in contact with an upper surface of the substrate and a side surface of the first electrode layer in each of the through-hole portions; and a light emitting portion that is formed in contact with the side surface of the first electrode layer, an upper surface of the second dielectric layer and the second electrode layer in each of the through-hole portions.

Here, a thickness of the second dielectric layer on the basis of the upper surface of the substrate is preferably thinner than a thickness of the first electrode layer. At an upper surface of the first dielectric layer, each of the through-hole portions preferably has a circular shape or a polygonal shape with a maximum width of 10 µm or less, or the through-hole portions are preferably formed in a belt-like shape parallel to each other with a width of 10 µm or less. In a case where the through-hole portions have the circular shape or the polygonal shape, 10³ to 10⁸ of the through-hole portions are preferably formed per arbitrary 1 mm square plane of the first dielectric layer. In a case where the through-hole portions have the belt-like shape, an interval between each of the through-hole portions is preferably 10 µm or less. The second dielectric layer is preferably composed of a material which is transparent to the visible light in the range of 400 nm to 750 nm.

Further, both a refractive index of the first dielectric layer and a refractive index of the second dielectric layer are preferably smaller than a refractive index of the first electrode layer, and a refractive index of the first dielectric layer is preferably smaller than a refractive index of the light emitting portion. A thickness of the first dielectric layer is preferably thinner than a thickness of the second dielectric layer. Each of the through-hole portions may include; a through-hole upper part that is formed to pass through at least the first electrode layer and the first dielectric layer; and a bored part that is formed in the substrate.

A method for manufacturing an organic light emitting element according to the present invention includes; a first process in which a first electrode layer is formed on a substrate; a second process in which plural through-holes passing through the first electrode layer are formed; a third process in which plural through-hole portions that include the through-holes and pass through the first electrode layer and a first dielectric layer are formed by forming the first dielectric layer on the first electrode layer and by forming a second dielectric layer to contact with an upper surface of the substrate and a side surface of the first electrode layer exposed to an inside of the through-holes; a fourth process in which a light emitting portion is formed to contact with the side surface of the first electrode layer exposed to an inside of the through-hole portions and an upper surface of the second electrode layer; and a fifth process in which a second electrode layer is formed to cover an upper part of the first dielectric layer and an upper part of the light emitting portion and to contact with the light emitting portion.

Here, the method preferably further includes a film thinning process in which a thickness of the first dielectric layer is made thin, between the third process and the fourth process, and preferably further includes a process in which a part of the first electrode layer covered with the first dielectric layer and/or the second dielectric layer is exposed, between the third process and the fourth process. In the second process, a bored part is preferably further formed in the substrate at a bottom portion of each of the through-hole portions.

Further, a method for manufacturing an organic light emitting element according to the present invention includes; a first process in which a first electrode layer is formed on a substrate; a second process in which a first dielectric layer is formed on the first electrode layer; a third process in which plural through-hole portions to pass through at least the first electrode layer and the first dielectric layer are formed; a fourth process in which, in the through-hole portions, a second dielectric layer is formed to contact with an upper surface of the substrate and a side surface of the first electrode layer exposed to an inside of the through-hole portions; a fifth process in which a light emitting portion is formed to contact with the side surface of the first electrode layer exposed to inside of the through-hole portions and an upper surface of the second electrode layer; and a sixth process in which a second electrode layer is formed to cover an upper part of the first dielectric layer and an upper part of the light emitting layer and to contact with the light emitting portion.

Here, the method may further include a process in which a part of the first electrode layer covered with the first dielectric layer and/or the second dielectric layer is exposed, between the fourth process and the fifth process. In the second process, a bored part is preferably further formed in the substrate at a bottom portion of each of the through-hole portions.

### Advantageous Effects of Invention

According to the present invention, an organic light emitting element which has high light extraction efficiency and high light emission efficiency can be provided.

### Brief Description of Drawings

FIG. 1 is a partial cross-sectional view for illustrating a first specific example of an organic light emitting element to which the exemplary embodiment is applied;
FIG. 2-1 is a diagram for illustrating a path of light emitted from the light emitting portion;
FIG. 2-2 is a diagram for illustrating a path of light emitted from the light emitting portion;
FIGS. 3A to 3C illustrate and explain other modes of the light emitting portion in the organic light emitting element to which the exemplary embodiment is applied;
FIG. 4 is a partial cross-sectional view illustrating a fifth specific example of an organic light emitting element to which the exemplary embodiment is applied;
FIG. 5 is a partial cross-sectional view illustrating a sixth specific example of an organic light emitting element to which the exemplary embodiment is applied;
FIG. 6 is a partial cross-sectional view illustrating a seventh specific example of an organic light emitting element to which the exemplary embodiment is applied;
FIGS. 7A to 7G are diagrams for illustrating the manufacturing method of the organic light emitting element to which the exemplary embodiment is applied;
FIG. 8 illustrates an organic light emitting element according to a comparative example 1; and
FIG. 9 illustrates an organic light emitting element according to a comparative example 3.

### Description of Embodiments

### (Organic light emitting element)

Hereinafter, an exemplary embodiment of the present invention will be described in detail with reference to the attached drawings.

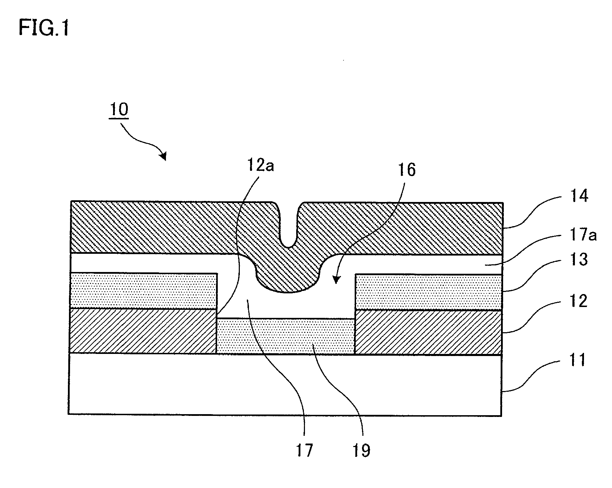

FIG. 1 is a partial cross-sectional view for illustrating a first specific example of an organic light emitting element to which the exemplary embodiment is applied.

An organic light emitting element 10 shown in FIG. 1 has a configuration in which a substrate 11, an anode layer 12 as a first electrode layer for injecting holes, which is formed on the substrate 11 in a case where the substrate 11 side is assumed to be the downside, a cathode layer 14 as a second electrode layer for injecting electrons, and a first dielectric layer 13 formed between the anode layer 12 and the cathode layer 14 are stacked. Further, the organic light emitting element 10 has through-hole portions 16 formed by passing through the anode layer 12 and the first dielectric layer 13, and a second dielectric layer 19 is, at an upper surface of the substrate 11 in each of the through-hole portions 16, formed to contact with the upper surface of the substrate 11 and a side surface of the anode layer 12. Furthermore, the organic light emitting element 10 includes a light emitting portion 17 which is formed on the second dielectric layer 19 to contact with the anode layer 12 inside of each of the through-hole portions 16 and is made of a light emitting material emitting light with application of voltage. The light emitting material constituting the light emitting portion 17 extends from the through-hole portions 16 to the top surface of the first dielectric layer 13 to form an extension portion 17a. In other words, the light emitting material constituting the light emitting portion 17 is successively formed to extend from the through-hole portions 16 to a region between the first dielectric layer 13 and the cathode layer 14. The cathode layer 14 is formed to be laminated on the light emitting material, and formed as a successive film similar to the light emitting portion 17.

The substrate 11 is a base material that serves as a support body for forming the anode layer 12, the first dielectric layer 13, the cathode layer 14, the light emitting portion 17 and the second dielectric layer 19. For the substrate 11, a material that satisfies mechanical strength required for the organic light emitting element 10 is used.

The material for the substrate 11, in the case where the light is to be taken out from the substrate 11 side of the organic light emitting element 10, is required to be transparent to the visible light. Specific examples include: glasses such as sapphire glass, soda glass and quartz glass; transparent resins such as acrylic resins, methacrylic resins, polycarbonate resins, polyester resins, nylon resins and silicon resins; and transparent metallic oxide such as aluminum nitride and alumina. In the case of using, as the substrate 11, a resin film or the like made of the aforementioned transparent resins, it is preferable that permeability to gas such as moisture and oxygen is low. In the case of using a resin film or the like having high permeability to gas, a thin film having a barrier property for inhibiting permeation of gas is preferably formed within a scope which does not impair the light transmission.

In the case where it is not necessary to take out the light from the substrate 11 side of the organic light emitting element 10, the material of the substrate 11 is not limited to the ones which are transparent to the visible light, and may be opaque to the visible light. Specific examples of the material of the substrate 11 include: in addition to the above-described materials, simple substances such as silicon (Si), copper (Cu), silver (Ag), gold (Au), platinum (Pt), tungsten (W), titanium (Ti), tantalum (Ta) and niobium (Nb); alloys thereof; stainless steel; oxides such as SiO₂, Al₂O₃ and the like; and a semiconductor material such as n-Si and the like.

Although the thickness of the substrate 11 depends on the required mechanical strength, it is preferably 0.1 mm to 10 mm, and more preferably 0.25 mm to 2 mm.

The anode layer 12 injects holes from the anode layer 12 to the light emitting portion 17 upon application of voltage between the anode layer 12 and the cathode layer 14. A material used for the anode layer 12 is necessary to have electric conductivity. Specifically, it has a large work function, and the work function is preferably not less than 4.5 eV. In addition, it is preferable that the electric resistance is not notably changed for an alkaline aqueous solution.

As the material satisfying such requirements, metal oxides, metals or alloys can be used. Examples of the metal oxides include indium tin oxide (ITO) and indium zinc oxide (IZO). Examples of the metals include copper (Cu), silver (Ag), gold (Au), platinum (Pt), tungsten (W), titanium (Ti), tantalum (Ta), niobium (Nb) and the like. Further, alloys such as stainless steel including these metals can be used. The thickness of the anode layer 12 is formed to be, for example, 2 nm to 2 µm. Note that, the work function can be measured by, for example, an ultraviolet photoelectron spectroscopy.

The first dielectric layer 13 refracts the light emitted from the light emitting portion 17, so that the light easily enters into the substrate 11.

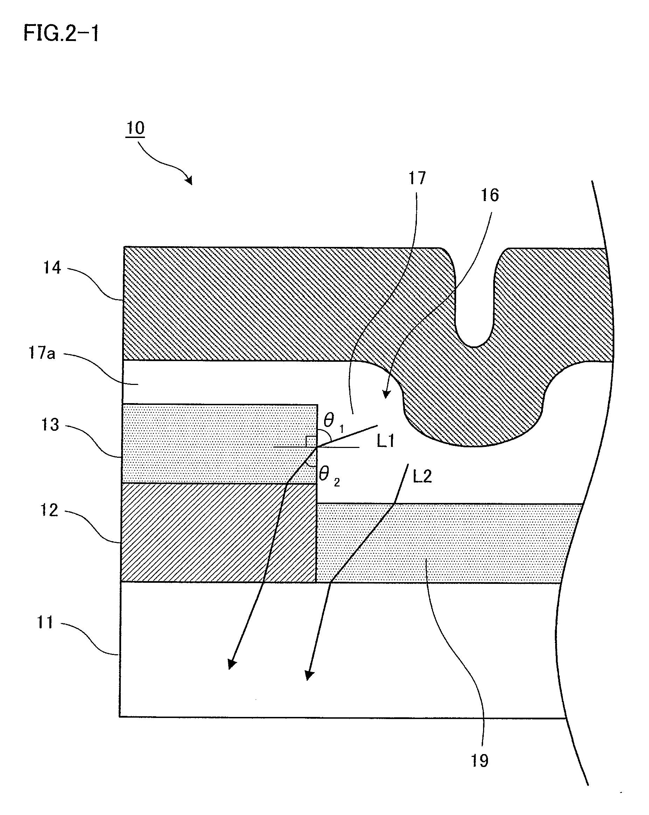

In the exemplary embodiment, the refractive index of the first dielectric layer 13 is lower than that of the light emitting portion 17. Therefore, as shown in FIG. 2-1 (a diagram for illustrating a path of light emitted from the light emitting portion 17), a light L1 emitted from the light emitting portion 17 is refracted at an angle closer to the normal direction of the substrate 11 when the light L1 enters into the first dielectric layer 13. That is, θ₁ > θ₂ is satisfied in FIG. 2-1. As a result, compared to a case in which the first dielectric layer 13 is not provided, total reflection of the light L1 having reached the anode layer 12 or the substrate 11 is not likely to occur at an interface between the first dielectric layer 13 and the anode layer 12 and at an interface between the anode layer 12 and the substrate 11. Accordingly, the light L1 tends to enter into the anode layer 12 or the substrate 11. Furthermore, in a case where a refractive index of the first dielectric layer 13 is smaller than that of the anode layer 12, the light L1 is similarly refracted at an angle closer to the normal direction of the substrate 11 also at an interface between the first dielectric layer 13 and the anode layer 12, and it becomes easy for the light L1 to enter into the substrate 11. In other words, by providing the first dielectric layer 13, more light emitted from the light emitting portion 17 can be extracted from a substrate 11 side, thereby the light extraction efficiency is improved.

In order to make the light emitting portion 17 emit light by applying a voltage to the light emitting portion 17 by way of the anode layer 12 and the cathode layer 14, the first dielectric layer 13 has a function of separating and insulating the anode layer 12 from the cathode layer 14 with a predetermined gap therebetween. Thus, it is necessary for the first dielectric layer 13 to be made of a material having high resistivity. The electric resistivity thereof is required to be not less than 10⁸ Ωcm, and preferably not less than 10¹² Ωcm. Specific examples of the material include: metal nitrides such as silicon nitride, boron nitride and aluminum nitride; metal oxides such as silicon oxide (silicon dioxide) and aluminum oxide; and metal fluorides such as sodium fluoride, lithium fluoride, magnesium fluoride, calcium fluoride and barium fluoride; and in addition, polymer compounds such as polyimide, polyvinylidene fluoride and parylene; and coating-type silicone such as poly (phenylsilsesquioxane) can be used.

Here, in order to manufacture, with high reproducibility, the organic light emitting element 10 that is less likely to be short-circuited and less likely to leak a current, the thicker the thickness of the first dielectric layer 13 is, the better. That is, as the thickness of the first dielectric layer 13 is thicker, it is easy to exclude or suppress influence of defects of the first dielectric layer 13 causing the short-circuit and the current leakage. Causes of such a short-circuit and a current leakage include; protrusions on a surface of the anode layer 12 on which the first dielectric layer 13 is formed; and pinholes of the first dielectric layer 13 which may occur in the manufacturing process of the first dielectric layer 13.

On the other hand, the thickness of the first dielectric layer 13 is preferably not more than 1 µm in order that the entire thickness of the organic light emitting element 10 may not become too thick. In addition, since the voltage necessary to emit light is lower as the space between the anode layer 12 and the cathode layer 14 is narrower, the first dielectric layer 13 is preferably thin from this viewpoint. However, if it is too thin, dielectric strength becomes possibly insufficient against the voltage for driving the organic light emitting element 10. Here, the dielectric strength is, in a state where the dielectric layer 13 is formed between the electrodes as a successive film in which the through-hole portions 16 are not formed, preferably not more than 0.1 mA/cm² of current density of a current passing thorough this dielectric layer when a voltage is higher by 2 V than that in driving the organic light emitting element 10, and more preferably not more than 0.01 mA/cm². The thickness of the first dielectric layer 13 that satisfies these requirements is preferably not more than 750 nm as the upper limit, more preferably not more than 400 nm, and still more preferably not more than 200 nm. The thickness of the first dielectric layer 13 is preferably not less than 15 nm as the lower limit, more preferably not less than 30 nm, and still more preferably not less than 50 nm.

The cathode layer 14 injects electrons into the light emitting portion 17 upon application of voltage between the anode layer 12 and the cathode layer 14. In the exemplary embodiment, the cathode layer 14 is formed as a successive film laminated on the light emitting portion 17 including the light emitting material in the through-hole portions 16 and on the light emitting material extended on the first dielectric layer 13.

The material used for the cathode layer 14 is not particularly limited as long as, similarly to that of the anode layer 12, the material has electrical conductivity; however, it is preferable that the material has a small work function and is chemically stable. Specific examples of the material include Al, MgAg alloy and alloys of Al and alkali metals such as AlLi and AlCa. The thickness of the cathode layer 14 is preferably in the range of 10 nm to 1 µm, and more preferably 50 nm to 500 nm. In the case of the organic light emitting element 10 of the exemplary embodiment, light emitted from the light emitting portion 17 is extracted from the substrate 11 side. Therefore, the cathode layer 14 may be formed by an opaque material. Note that, if light is intended to be extracted from not only the substrate 11 side but also the cathode layer 14 side by using the configuration of the cathode layer 14 as a successive film covering the light emitting portion 17 as shown in the exemplary embodiment, it is necessary for the cathode layer 14 to be made of a transparent material such as ITO.

To lower the barrier for the electron injection from the cathode layer 14 into the light emitting portion 17 and thereby to increase the electron injection efficiency, a cathode buffer layer that is not shown may be provided adjacent to the cathode layer 14. A work function of a material used for the cathode buffer layer is preferably lower than a work function of a material for the cathode layer 14, and a metallic material may be used therefor. For example, the material thereof includes alkali metals (Na, K, Rb and Cs), alkaline earth metals (Sr, Ba, Ca and Mg), rare earth metals (Pr, Sm, Eu and Yb), one selected from fluoride, chloride and oxide of these metals and mixture of two or more selected therefrom. The thickness of the cathode buffer layer is preferably in the range of 0.05 nm to 50 nm, more preferably 0.1 nm to 20 nm, and still more preferably 0.5 nm to 10 nm.

Each of the through-hole portions 16 is provided with the light emitting portion 17 formed inside thereof, and is provided for extracting the light from the light emitting portion 17. In the exemplary embodiment, each of the through-hole portions 16 is formed by passing through the anode layer 12 as the first electrode layer and the first dielectric layer 13. By providing the through-hole portions 16 as described above, the light emitted from the light emitting portion 17 is transmitted within the through-hole portions 16, and the light can be extracted in both directions which are the substrate 11 side and the cathode layer 14 side. Here, since each of the through-hole portions 16 is formed so as to pass through the anode layer 12 and the first dielectric layer 13, it is possible to extract the light from the substrate 11 side even when the anode layer 12 serving as the first electrode layer and the cathode layer 14 serving as the second electrode layer are made of an opaque material.

The shape of the through-hole portions 16 is not particularly limited, however, for easily controlling the shape thereof, it is preferable that the shape of the through-hole portions 16 is a cylindrical shape or a polygonal prism such as square prism, for example. In other words, in this case, the shape of the through-hole portions 16 is circular or polygonal at the upper surface of the first dielectric layer 13. In these shapes, shape in the upper surface of the first dielectric layer 13 may be varied in the thickness direction of the first dielectric layer 13 and the anode layer 12, or size of the shape may be varied. That is, the shapes may be, for example, conic, pyramid, truncated cone, or truncated pyramid. By arbitrarily selecting the shape of the through-hole portions 16, it is possible to control light distribution or the like when the light emitted from the light emitting layer 14 is extracted outside.

In the organic light emitting element 10 of the exemplary embodiment, if the distance between each of the through-hole portions 16 is set to be small in a case where light is strongly emitted at the through-hole portions 16, emission intensity is set to be large since the number of the through-hole portions 16 per unit area is increased. Further, the light emitting portion 17 tends to emit light in the vicinity of the anode layer 12 and the cathode layer 14. In other words, the central part of each of the through-hole portions 16 is likely to be a non-light-emitting area, and if the non-light-emitting area is large, the organic light emitting element 10 is hard to emit light with high brightness. Therefore, if the width of each of the through-hole portions 16 is set to be small, the emission intensity is easy to be set large since the non-light-emitting area at the central part of each of the through-hole portions 16 is decreased. Specifically, each of the through-hole portions 16 preferably has a width (W) of not more than 10 µm, more preferably not more than 2 µm, and further preferably not more than 1 µm. Moreover, from a view point of easy productivity, the width is preferably not less than 0.1 µm, and more preferably not less than 0.5 µm. Note that, "the width of each of the through-hole portions 16" indicates the maximum width of a shape of each of the through-hole portions 16 at the upper surface of the first dielectric layer 13, in other words, a diameter of the minimum circle enclosing the shape.

Arrangement of the through-hole portions 16 on the first dielectric layer 13 may be regular one such as square-lattice pattern or hexagonal-lattice pattern, or may be irregular one, and 10³ to 10⁸ of the through-hole portions 16 are preferably formed per arbitrary 1 mm square plane of the first dielectric layer 13. This arrangement is arbitrarily selected from view points of wavelength of light emitted from the light emitting portion 17, light distribution emitted from the organic light-emitting element 10, or spectrum control.

The shape of each of the through-hole portions 16 may be a belt-like shape parallel to each other. Also in this case, an upper limit width of each of the through-hole portions 16 is preferably not more than 10 µm, more preferably not more than 2 µm, and further preferably not more than 1 µm, and a lower limit width of each of the through-hole portions 16 is preferably not less than 0.1 µm, and more preferably not less than 0.5 µm, with the same reason described above. The interval between each of the through-hole portions 16 which are plural belt-like shape is preferably not more than 10 µm, and more preferably not more than 2 µm, and from a view point of easiness of the production, the interval is preferably not less than 0.1 µm, and more preferably not less than 0.5 µm.

The light emitting portion 17 is made of a light emitting material that emits light by application of voltage and current supply, and is formed to be in contact with the side surface of the anode layer 12 in the through-hole portions 16 and with the cathode layer 14. In the light emitting portion 17, holes injected from the anode layer 12 and the electrons injected from the cathode layer 14 are recombined, and light emission occurs.

As the material of the light emitting portion 17, either an organic material or an inorganic material may be used. In a case where an organic material is used as the light emitting material, any one of publicly-known low-molecular compound and high-molecular compound may be used. However, in the exemplary embodiment, a material having an excellent coating property is preferable. In other words, in the structure of the organic light emitting element 10 in the exemplary embodiment, for stable light emission of the light emitting portion 17 in the through-hole portions 16, it is preferable for the light emitting portion 17 to be uniformly deposited on. the inner surface of the through-hole portions 16 with a uniform thickness, that is, to have an improved coverage property. If the light emitting portion 17 is formed without using a material having an excellent coating property, the light emitting portion 17 tends to be formed not uniformly in contact with the whole through-hole portions 16, or in a non-uniform thickness in the through-hole portion 16. Thereby, unevenness of brightness of light output from the through-hole portions 16 is easily caused.

Further, in order to form the light emitting portion 17 uniformly in the through-hole portions 16, a coating method is preferably adopted. In other words, in the coating method, since it is easy to fill a light emitting material solution including a light emitting material in the through-hole portions 16, film formation with high coverage property can be achieved even on a surface having a concave and a convex. In the coating method, a material having mainly a weight average molecular weight of 1,000 to 2,000,000 is preferably used to improve the coating property. Moreover, it is possible to add additives for improving the coating property such as a leveling agent and a defoaming agent, or to add a binder resin having low charge trapping capability.

Specifically, examples of material having an excellent coating property include: arylamine compound having a predetermined structure with a molecular weight of 1,500 or more to 6,000 or less disclosed in Japanese Patent Application Laid Open Publication No. 2007-86639; and a predetermined high molecular phosphor disclosed in Japanese Patent Application Laid Open Publication No. 2000-034476.

Among the material having the excellent coating property, a light emitting high-molecular compound may be preferable in terms of simplification of manufacturing process of the organic light emitting element 10, and a phosphorescent light emitting compound may be preferable in terms of high light emitting efficiency. Accordingly, a phosphorescent light emitting high-molecular compound is particularly preferable. Note that, it is possible to mix plural materials or to add a low molecular light emitting material (for example, molecular weight of not more than 1,000) within a scope which does not impair the coating property. On this occasion, an amount of adding the low molecular light emitting material is preferably not more than 30 wt%.

Further, the light emitting high-molecular compound may be classified into a conjugated light emitting high-molecular compound and a non-conjugated light emitting high-molecular compound; however, among these, the non-conjugated light emitting high-molecular compound may be preferable.

From the aforementioned reasons, as the light emitting material used in the exemplary embodiment, a phosphorescent light emitting non-conjugated high-molecular compound (a light emitting material which is a phosphorescent light emitting polymer and also a non-conjugated light emitting high-molecular compound) is especially preferable.

The light emitting portion 17 of the organic light emitting element 10 according to the present invention preferably includes at least the phosphorescent light emitting polymer (phosphorescent light emitting organic material) in which one molecule contains a phosphorescent light emitting unit that emits phosphorescent light and a carrier transporting unit that transports a carrier. The phosphorescent light emitting polymer is obtained by copolymerizing a phosphorescent light emitting compound having a polymerizable substituent and a carrier-transporting compound having a polymerizable substituent. The phosphorescent light emitting compound is a metal complex containing a metallic element selected from iridium (Ir), platinum (Pt) and gold (Au), and especially, an iridium complex is preferable.

Specific examples of the carrier-transporting compound having a polymerizable substituent include a compound in which one or more hydrogen atoms in an organic compound having any one or both of a hole transport property and an electron transport property are substituted by polymerizable substituents.

As a polymerization procedure for polymerizing a phosphorescent light emitting compound having a polymerizable substituent and a carrier-transporting compound having a polymerizable substituent, any of a radical polymerization, a cationic polymerization, an anionic polymerization, and an addition polymerization is acceptable. However, a radical polymerization is preferable. A molecular weight of the polymer is preferably, as a weight-average molecular weight, 1,000 to 2,000,000, and more preferably 5,000 to 1,000,000. The molecular weight in the exemplary embodiment is a polystyrene-converted molecular weight measured by a gel permeation chromatography (GPC).

The phosphorescent light emitting polymer may be made by copolymerizing a phosphorescent light emitting compound and a carrier-transporting compound, or a phosphorescent light emitting compound and two or more kinds of carrier-transporting compounds. Alternatively, it may be made by copolymerizing two or more kinds of phosphorescent light emitting compounds and a carrier-transporting compound.

As a monomer sequence of the phosphorescent light emitting polymer, any of a random copolymer, a block copolymer, and an alternate copolymer is acceptable. If the number of repeating units of a structure of the phosphorescent light emitting compound is denoted by m, and the number of repeating units of a structure of the carrier-transporting compound is denoted by n (m and n are integers not less than 1), a proportion of the number of the repeating units of the structure of the phosphorescent light emitting compound to the total number of the repeating units, that is, the value of m / (m + n) is preferably in a range of 0.001 to 0.5, and more preferably in a range of 0.001 to 0.2.

The light emitting portion 17 of the organic light emitting element 10 according to the exemplary embodiment preferably includes the aforementioned phosphorescent light emitting compound, and may include a hole-transporting compound or an electron-transporting compound in order to supplement the carrier transport property of the light emitting portion 17. Specific examples of the hole-transporting compound used for this purpose include low molecular triphenylamine derivatives such as: TPD (N,N'-diphenyl-N,N'-(3-methylphenyl)-1,1'-biphenyl-4,4'diamine), α-NPD (4,4'-bis[N-(1-naphthyl)-N-phenylamino]biphenyl); and m-MTDATA (4,4',4"-tris(3-methylphenylphenylamino)triphenylamine). In addition, specific examples also include: polyvinylcarbazole; triphenylamine derivative-based high-molecular compound polymerized by introducing a polymerizable functional group; a polymer compound having a triphenylamine skeleton disclosed in Japanese Patent Application Laid Open Publication No. 8-157575; polyparaphenylenevinylene; and polydialkylfluorene. Further, specific examples of the electron-transporting compound include low molecular material such as: a quinolinol derivative metal complex such as trisquinolinolato aluminum (Alq3); an oxadiazole derivative; a triazole derivative; an imidazole derivative; a triazine derivative; and a triarylborane derivative. Specific examples further include a compound obtained by polymerizing the aforementioned low-molecular electron-transporting compound by introducing the polymerizable functional group, for instance, known electron-transporting compounds such as polyPBD disclosed in Japanese Patent Application Laid Open Publication No. 10-1665.

Even in the case of using a light emitting low-molecular compound instead of the aforementioned light emitting polymeric compound as a light emitting material used for the light emitting portion 17, the light emitting portion 17 can be formed. Further, it is also possible to add the aforementioned light emitting polymer compound as a light emitting material, and to add the hole-transporting compounds or the electron-transporting compounds.

Specific examples of the hole-transporting compounds in this case include, for example, TPD, α-NPD, m-MTDATA, phthalocyanine complex, DTDPFL, spiro-TPD, TPAC, PDA and the like disclosed in Japanese Patent Application Laid Open Publication No. 2006-76901.

Specific examples of the electron-transporting compound include, for example, BPhen, BCP, OXD-7 and TAZ disclosed in Japanese Patent Application Laid Open Publication No. 2006-76901.

Further, for example, a compound having a bipolar molecular structure having the hole transport property and the electron transport property in one molecule, which is disclosed in Japanese Patent Application Laid Open Publication No. 2006-273792, is also usable.

The light emitting portion 17, between the anode layer 12 and the cathode layer 14, may have a single layer structure which is composed only by the single light emitting layer formed by the light emitting material, and may have a laminated structure which includes a layer except for the light emitting layer or includes plural light emitting layers. In a case where a layer except for the light emitting layer is included, a hole injection layer, a hole transport layer or an electron block layer are exemplified as a layer formed between the light emitting layer and the anode layer 12, and an electron transport layer or a hole block layer are exemplified as a layer formed between the light emitting layer and the cathode layer 14. Each of these layers is formed by depositing the hole-transporting compounds or the electron-transporting compounds which are described above by methods such as a resistance heating deposition method, an electron beam deposition method, a sputtering method, a spin coating method, a dip coating method, an ink-jet printing method, a printing method, a spray-coating method and a dispenser-printing method.

The second dielectric layer 19 is a layer for making more light entered into the substrate 11 by providing it. In the exemplary embodiment, the refractive index of the second dielectric layer 19 is preferably lower than that of the light emitting portion 17.

Further, the second dielectric layer 19 is preferably formed by a material which is transparent to the visible light in the range of 400 nm to 750 nm. In particular, the light transmission in the wavelength range of light to be extracted is preferably higher than that of the light emitting portion 17 compared in the same length of light path.

In the case where the second dielectric layer 19 is provided, compared to the case where it is not provided, the light extraction efficiency is improved. In other words, if the second dielectric layer 19 is not provided and the part is filled with the light emitting material, the light emitted from the light emitting portion 17 is easy to be attenuated since the light transmission of the light emitting material is lower than that of the second dielectric layer 19. On the other hand, by providing the second dielectric layer 19, as shown in FIG. 2-1, a light L2 that is emitted from the light emitting portion 17 and passes through the second dielectric layer 19 is less attenuated and reaches the substrate 11. As a result, more light emitted from the light emitting portion 17 can be extracted at a substrate 11 side, thereby the light extraction efficiency is improved.

In a part where the through-hole portions 16 are provided in the exemplary embodiment, the anode layer 12 does not exist. Therefore, at this part, such an occasion does not occur that the intensity of the light entering into the anode layer 12 is largely attenuated due to the low light transmission of the anode layer 12. Therefore, also in this point, from the view point of the light extraction efficiency, the organic light emitting element 10 in the exemplary embodiment is favorable.

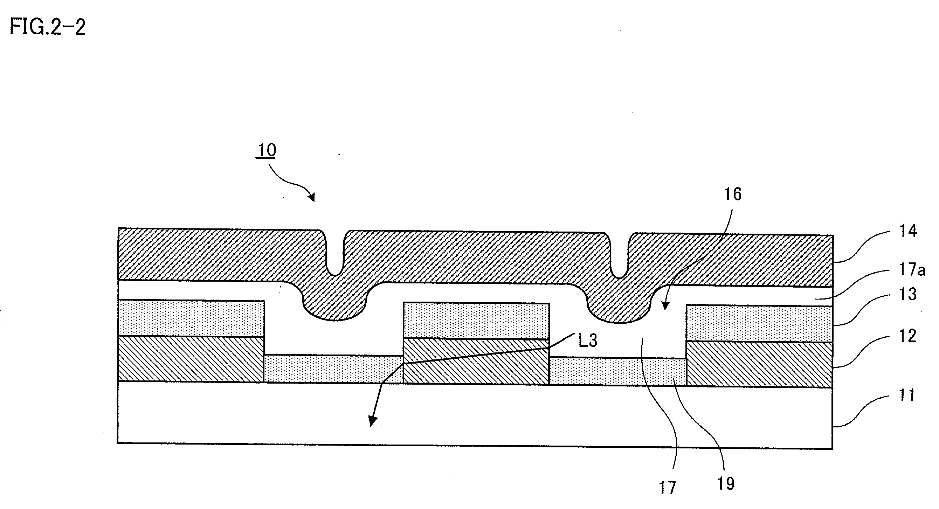

In a case where the second dielectric layer 19 is not formed, a part of light having entered from the light emitting portion 17 into the anode layer 12 is confined inside of the anode layer 12 and it is not possible to extract the light to outside, since the refractive index of the anode layer 12 is larger than that of the substrate 11 or that of the first dielectric layer 13. In the organic light emitting element 10, since the path of light is changed to the substrate 11 side as a light L3 shown in FIG. 2-2 by passing through the second dielectric layer 19 formed in the adjacent through-hole portions 16, such a light having entered into the anode layer 12 is able to be extracted to outside, thereby the light extraction efficiency is more improved. For this, furthermore, the refractive index of the second dielectric layer 19 is preferably smaller than that of the anode layer 12. That is, light extraction efficiency in the organic light emitting element 10 is particularly high when both the refractive index of the first dielectric layer 13 and the refractive index of the second dielectric layer 19 are smaller than the refractive index of the anode layer 12.

The second dielectric layer 19 is formed to have a thickness with which the side surface of the anode layer 12 is exposed in each of the through-hole portions 16. That is, the second dielectric layer 19 is formed so that an upper surface of the second dielectric layer 19 is lower than the upper surface of the anode layer 12 by 1 nm or more, more preferably by 10 nm or more. It should be noted that, as much as in the range of the film thickness, the second dielectric layer 19 is formed to preferably have a thickness of 1 nm or more, and more preferably 10 nm or more on the basis of the upper surface of the substrate 11.

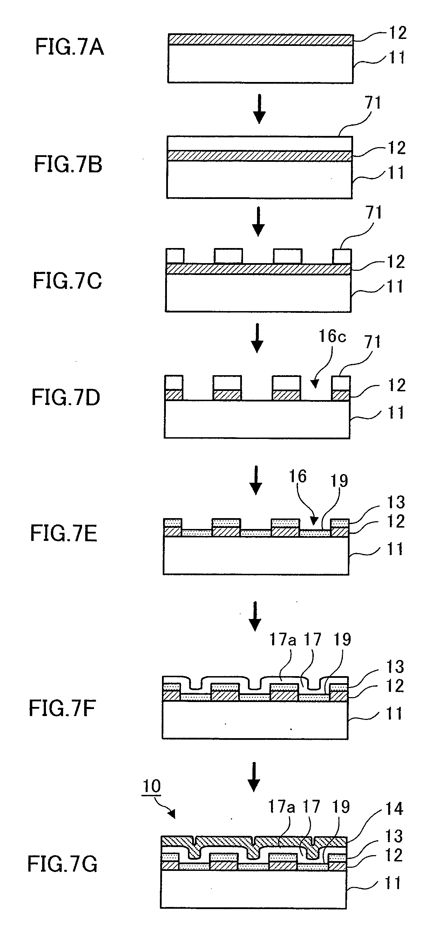

In the exemplary embodiment, the second dielectric layer 19 and the first dielectric layer 13 may be formed of a different material or be formed of the same material. However, by forming them with the same material, as will be described later in FIG. 7E, the second dielectric layer 19 and the first dielectric layer 13 can be formed in one forming process, and thereby it becomes more easy to produce the organic light emitting element 10.

Note that, since both the first dielectric layer 13 and the second dielectric layer 19 have insulation properties, it is required that the second dielectric layer 19 is formed so that the thickness thereof is thinner than that of the anode layer 12 and the side surface of the light emitting portion 17 is in contact with a side surface 12a of the anode layer 12. Accordingly, the anode layer 12 and the light emitting portion 17 are electrically conducted, and current can flow from the anode layer 12 to the light emitting portion 17.

The organic light emitting element 10 that has been described above in detail is not limited to the organic light emitting element in which the light emitting portion 17 is spread and formed not only inside of the through-hole portions 16 but also at the upper surface of the first dielectric layer 13.

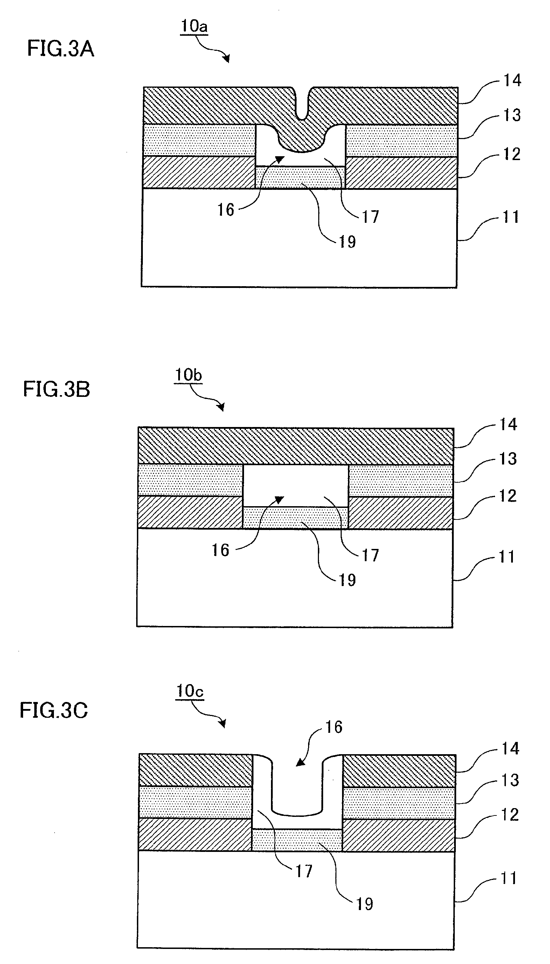

FIGS. 3A to 3C illustrate and explain other modes of the light emitting portion 17 in the organic light emitting element to which the exemplary embodiment is applied. These are the specific second to fourth examples of the organic light emitting element to which the exemplary embodiment is applied.

An organic light emitting element 10a in FIG. 3A shows a case where the light emitting portion 17 is formed inside the through-hole portions 16 but the light emitting portion 17 is not formed at the upper surface of the first dielectric layer 13.

Further, an organic light emitting element 10b in FIG. 3B shows a case where the light emitting portion 17 is not formed at the upper surface of the first dielectric layer 13, and the whole through-hole portion 16 is filled with the light emitting portion 17. By this configuration, the cathode layer 14 is formed in a planar state.

Furthermore, an organic light emitting element 10c in FIG. 3C shows a case where the through-hole portions 16 are provided also in the cathode layer 14, and the light emitting portion 17 is formed so as to be located along the inside of the through-hole portions 16 on the second dielectric layer 19. In this configuration, only part of the through-hole portions 16 is filled with the light emitting portion 17. Further, since the through-hole portions 16 are formed also in the cathode layer 14, even if the cathode layer 14 is made of an opaque material, light is extracted not only from the substrate 11 side but also from the cathode layer 14 side.

Also in these organic light emitting elements 10a, 10b and 10c, by providing the first dielectric layer 13 and the second dielectric layer 19, light extraction efficiency is improved.

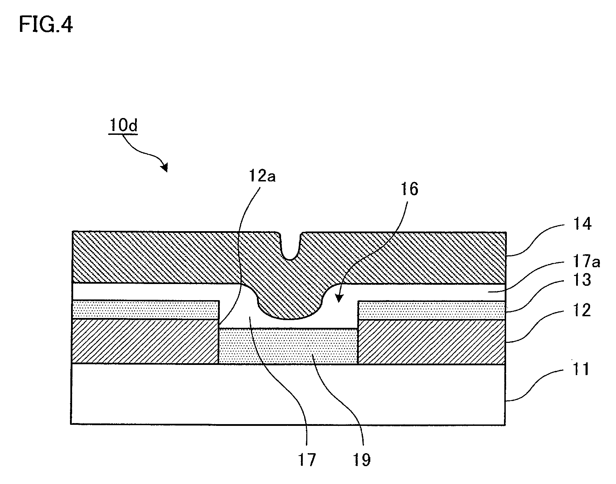

FIG. 4 is a partial cross-sectional view illustrating a fifth specific example of an organic light emitting element to which the exemplary embodiment is applied.

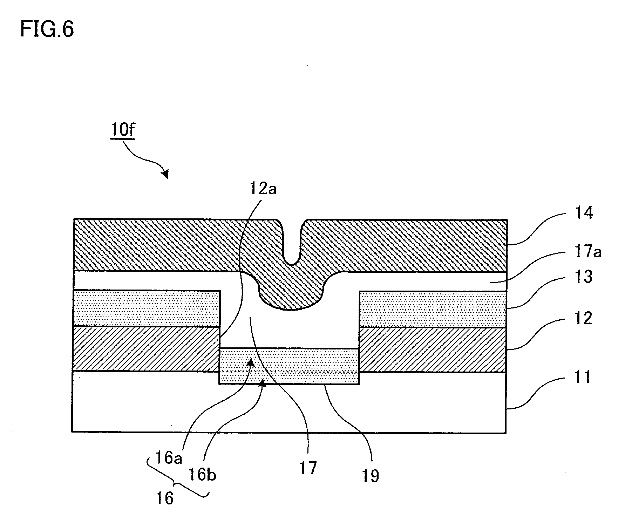

In an organic light emitting element 10d in FIG. 4, the positional relationship of the substrate 11, the anode layer 12, the first dielectric layer 13, the cathode layer 14, the through-hole portions 16, the light emitting portion 17 and the second dielectric layer 19 is similar to that of the organic light emitting element 10 shown in FIG. 1. However, the organic light emitting element 10d is produced so that the thickness of the first dielectric layer 13 is thinner than that of the second dielectric layer 19. By this configuration, the step between the first dielectric layer 13 and the second dielectric layer 19 can be made smaller. Accordingly, coverage property is improved when the light emitting portion 17 and the extension portion 17a are formed by coating the light emitting material as will be described later in FIG. 6. Therefore the light emitting portion 17 and the extension portion 17a are formed more stably.

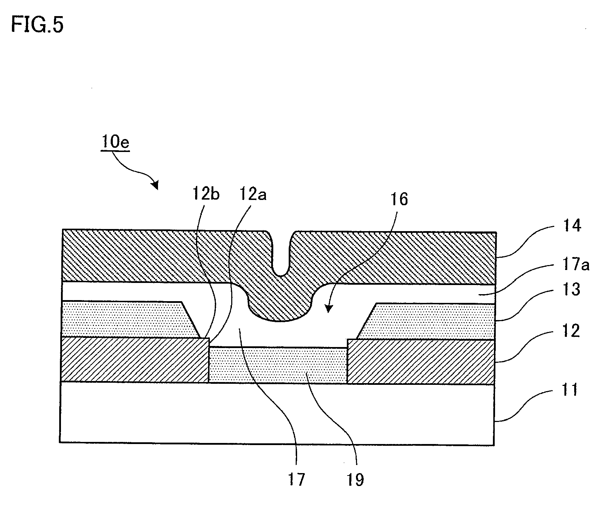

FIG. 5 is a partial cross-sectional view illustrating a sixth specific example of an organic light emitting element to which the exemplary embodiment is applied.

In an organic light emitting element 10e in FIG. 5, the positional relationship of the substrate 11, the anode layer 12, the first dielectric layer 13, the cathode layer 14, the through-hole portions 16, the light emitting portion 17 and the second dielectric layer 19 is similar to that of the organic light emitting element 10 shown in FIG. 1. However, the difference is the following point that the cross-sectional shape of the first dielectric layer 13 is a tapered shape at an end portion thereof to contact the through-hole portions 16. By this configuration, a volume of the light emitting portion 17 emitting light between the anode layer 12 and the cathode layer 14 is increased, thus the light emitted from the light emitting portion 17 is likely to be increased.

Additionally, the organic light emitting element 10e is further different, with respect to the organic light emitting element 10, in that the light emitting portion 17 is in contact with an upper surface 12b of the anode layer 12. By this configuration, even if the volume of the light emitting portion 17 is increased, sufficient current is applied from the anode layer 12.

It should be noted that, even if the end portion of the first dielectric layer 13 is formed as in the exemplary embodiment, the light emitted from the light emitting portion 17 is refracted at an angle near the normal direction when entering into the first dielectric layer 13.

FIG. 6 is a partial cross-sectional view illustrating a seventh specific example of an organic light emitting element to which the exemplary embodiment is applied.

In an organic light emitting element 10f in FIG. 6, the positional relationship of the substrate 11, the anode layer 12, the first dielectric layer 13, the cathode layer 14, the through-hole portions 16, the light emitting portion 17 and the second dielectric layer 19 is similar to that of the organic light emitting element 10 shown in FIG. 1. However, each of the through-hole portions 16 includes; a through-hole upper part 16a that is formed to pass through the anode layer 12 and the first dielectric layer 13; and a bored part 16b that is formed in the substrate 11. By forming the bored part 16b like this, the thickness of the second dielectric layer 19 is set to be large by the depth of the bored part 16b. That is, by adjusting the depth of the bored part 16b, the thickness of the second dielectric layer 19 can be adjusted. The bored part 16b may be formed with a depth of 1 nm to 1000 nm from the upper surface of the substrate 11.

Note that, in the organic light emitting elements 10 and 10a to 10f having been described above in detail, description has been given for a case where the anode layer 12 is formed on the lower side and the cathode layer 14 is formed on the upper side through the first dielectric layer 13 so as to face thereto if the substrate 11 side is set as a lower side, as an example. However, the structure is not limited to the above, and a structure in which the anode layer 12 and the cathode layer 14 are exchanged each other may be provided. In other words, a configuration where the cathode layer 14 is formed on the lower side and the anode layer 12 is formed on the upper side through the first dielectric layer 13 so as to face thereto if the substrate 11 side is set as a lower side is also provided.

### (Manufacturing method of organic light emitting element)

Next, description will be given for a manufacturing method of the organic light emitting element to which the exemplary embodiment is applied, while the organic light emitting element 10 described with FIG. 1 is taken as an example.

FIGS. 7A to 7G are diagrams for illustrating the manufacturing method of the organic light emitting element 10 to which the exemplary embodiment is applied.

First, on the substrate 11, the anode layer 12 as a first electrode layer is formed (FIG. 7A). In the exemplary embodiment, a glass substrate is used as the substrate 11. Further, ITO is used as a material for forming the anode layer 12.

For forming the anode layer 12 on the substrate 11, a resistance heating deposition method, an electron beam deposition method, a sputtering method, an ion plating method, a CVD method or the like may be used. Alternatively, if a film-forming method, that is, a method for applying a suitable material solved in a solvent to the substrate 11 and then drying the same is applicable, the anode layer 12 can be formed by a spin coating method, a dip coating method, an ink-jet printing method, a printing method, a spray-coating method and a dispenser-printing method or the like.

Next, a through-hole 16c is formed so as to pass through the anode layer 12. For forming the through-hole 16c, a method using lithography may be used, for example. To form the through-hole portions 16, first, a resist solution is applied on the anode layer 12 and then an excess resist solution is removed by spin coating or the like to form a resist layer 71 (FIG. 7B).

Thereafter, the resist layer 71 is covered with a mask (not shown), in which a predetermined pattern for forming the through-hole 16c is rendered, and is exposed with ultraviolet light (UV), an electron beam (EB) or the like. Then, the predetermined pattern corresponding to the through-hole 16c is exposed onto the resist layer 71. Thereafter, light exposure portions of the resist layer 71 are removed by use of a developing solution, exposed pattern portions of the resist layer 71 are removed (FIG. 7C). By this process, the surface of the anode layer 12 is exposed so as to correspond to the exposed pattern portions.

Then, by using the remaining resist layer 71 as a mask, exposed portions of the anode layer 12 are removed by etching (FIG. 7D). Either dry etching or wet etching may be used as the etching. Further, by combining isotropic etching and anisotropic etching at this time, the shape of the through-hole 16c can be controlled. Reactive ion etching (RIE) or inductive coupling plasma etching is used as the dry etching, and a method of immersion in diluted hydrochloric acid, diluted sulfuric acid, or the like is used as the wet etching. By the etching, the surface of the substrate 11 is exposed so as to correspond to the aforementioned pattern.

Next, the residual resist layer 71 is removed by using a resist removing solution, and the first dielectric layer 13 and the second dielectric layer 19 are formed (FIG. 7E). In the exemplary embodiment, silicon dioxide (SiO₂) is used as a material for forming the first dielectric layer 13. Similarly to the formation of the anode layer 12, a resistance heating deposition method, an electron beam deposition method, a sputtering method, an ion plating method, a CVD method, a coating method or the like may be used for forming the first dielectric layer 13. By using these methods, the first dielectric layer 13 and the second dielectric layer 19 are formed together. The first dielectric layer 13 is formed to be laminated on the anode layer 12 so that the through-hole portions 16 are formed, and the second dielectric layer 19 is formed at a bottom portion of each the through-hole portions 16. It should be noted that it is possible to separately form the first dielectric layer 13 and the second dielectric layer 19. However, by forming the first dielectric layer 13 and the second dielectric layer 19 which are composed of the same material together as in the exemplary embodiment, it becomes easier to produce the organic light emitting element 10.

It should be noted that, in a case where the first dielectric layer 13 and the second dielectric layer 19 are formed in different processes, for example, the anode layer 12 is formed on the substrate 11 and the first dielectric layer 13 is formed on the anode layer 12. Then, the through-hole portions 16 to pass through the anode layer 12 and the first dielectric layer 13 are formed, thereafter, the second dielectric layer 19 is formed in each of the through-hole portions 16. In this case, the anode layer 12, first dielectric layer 13, the through-hole portions 16 and the second dielectric layer 19 are formed in the same method described above.

Next, the light emitting portion 17 containing the light emitting material is formed on the first dielectric layer 13 and the second dielectric layer 19 (FIG. 7F). For forming the light emitting portion 17, the above-mentioned coating method described in the explanation on the light emitting portion 17 is used. Specifically, light emitting material solution in which the light emitting material for the light emitting portion 17 is dispersed in predetermined solvent such as organic solvent or water is firstly applied. To perform coating, various methods such as a spin coating method, a spray coating method, a dip coating method, an ink-jet method, a slit coating method, a dispenser method and a printing method may be used. After the coating is performed, the light emitting material solution is dried by heating or vacuuming, and thereby the light emitting material adheres to the inner surface of the through-hole portions 16 to form the light emitting portion 17. At this time, the light emitting portion 17 is formed so as to spread onto the first dielectric layer 13. By adopting this configuration, manufacture of the organic light emitting element 10 is easier than the case where the light emitting portion 17 is formed only at the inside of the through-hole portions 16, since it is not necessary to remove the coating liquid applied on the portions other than the through-hole portions 16 after the coating.

Then, the cathode layer 14 as a second electrode layer is formed so as to be stacked on the light emitting portion 17 (FIG. 7G). A method similar to the method for forming the anode layer 12 is performed to form the cathode layer 14.

By the aforementioned processes, the electroluminescence element 10 is manufactured.

In the manufacturing method of organic light emitting element according to the exemplary embodiment, a process for forming the through-hole 16c is provided next to a process for forming the anode layer 12. Therefore, the exemplary embodiment has following advantages compared to the case where the first dielectric layer 13 is formed next to the process for forming the anode layer 12, and the anode layer 12 and the first dielectric layer 13 are etched to form the through-hole portions 16.
(1) If the two layers of the anode layer 12 and the first dielectric layer 13 are etched, there are some cases in which the resist layer 71 is lost in the process by etching, and processing of the predetermined pattern is not achieved. However, such a situation hardly occurs in the exemplary embodiment.
(2) If the two layers of the anode layer 12 and the first dielectric layer 13 are etched, the material forming the first dielectric layer 13 is limited to the material that is able to be patterned in the process for forming the through-hole portions 16. However, there is no such a limitation in the exemplary embodiment.
(3) If the two layers of the anode layer 12 and the first dielectric layer 13 are etched, the first dielectric layer 13 is limited to the one whose property does not change in the process for forming the through-hole portions 16. However, there is no such a limitation in the exemplary embodiment.

For manufacturing the organic light emitting element 10d shown in FIG. 4, an anisotropic etching may be performed after a process for forming the dielectric layer shown in FIG. 7E described above. By anisotropic etching, the first dielectric layer 13 is etched prior to the second dielectric layer 19, thus the thickness of the first dielectric layer 13 is made thinner than that of the second dielectric layer 19. This process may be considered as a film thinning process in which the thickness of the first dielectric layer 13 is made thin between the process for forming the dielectric layer and a process for forming the light emitting portions 17.

For manufacturing the organic light emitting element 10e shown in FIG. 5, an isotropic etching may be performed after a process for forming the dielectric layer shown in FIG. 7E described above. That is, since the end portion of the first dielectric layer 13 is etched isotropically, the end portion of the first dielectric layer 13 is removed to be a tapered shape. This process may be considered as an electrode layer exposure process in which a part of the first anode layer 12 is exposed between the process for forming the dielectric layer and the process for forming the light emitting portion 17.

When the second dielectric layer 19 is formed, there is a case in which the side surface of the anode layer 12 in the through-hole portions 16 is covered with a thin layer of a material constituting the second dielectric layer 19 beyond necessity. In this case, it may be difficult to inject electrons into the light emitting portion 17 from the anode layer 12. To address this, the side surface of the anode layer 12 should be properly exposed by removing such a thin layer by performing the same etching as the etching in the above-described electrode layer exposure process.

Further, for manufacturing the organic light emitting element 10f shown in FIG. 6, a part of the substrate 11 is further removed by boring after a process of removing the anode layer 12 as shown in FIG. 7D described above. By this performance, the bored part 16b is formed. For removing a part of the substrate 11, methods using etching similar to those explained in FIG. 7E can be employed.

Further, after the sequence of these processes, a protective layer or a protective cover (not shown) for stably using the organic light emitting element 10 for long periods and protecting the organic light emitting element 10 from outside may be mounted. As the protective layer, polymer compounds, metal oxides, metal fluorides, metal borides, or silicon compounds such as silicon nitrides and silicon oxides may be used. A lamination thereof may also be used. As the protective cover, glass plates, plastic plates with a surface treated with low hydraulic permeability, or metals may be used. The protective cover may be bonded to the substrate 11 by using a thermosetting resin or a photo-curable resin to be sealed. At this time, spacers may be used so that predetermined spaces are maintained, thus the prevention of scratches on the organic light emitting element 10 is facilitated. Filling the spaces with inert gases such as nitrogen, argon and helium prevents the oxidation of the cathode layer 14 on the upper side. Especially, in the case of using helium, it is preferable since high thermal conductivity thereof enables heat generated from the organic light emitting element 10 upon application of voltage to be effectively transmitted to the protective cover. In addition, by putting desiccants such as barium oxide in the spaces, the organic light emitting element 10 is easily prevented from being damaged by moisture absorbed in the sequence of the aforementioned manufacturing processes.

### Examples

### (Example 1)

### [Preparation of phosphorescent light emitting polymer compound]

The following compounds expressed by the chemical formulas E-2 (iridium complex having a polymerizing substituent), E-54 (hole transporting compound) and E-66 (electron transporting compound) were dissolved in dehydrated toluene with the ratio (mass ratio) of E-2:E-54:E-66 = 1:4:5, and V-601 (manufactured by Wako Pure Chemical Industries, Ltd.) as a polymeric initiator was further dissolved therein. After freeze pumping operation, vacuum seal was performed, and the resultant solution was stirred for 100 hours at 70 degrees C for polymerization reaction. After the reaction, the reaction solution was delivered by drops into acetone to cause deposition, and then reprecipitation purification with dehydrated toluene-acetone was repeated three times to purify the phosphorescent light emitting polymer compound. Here, as each of dehydrated toluene and acetone, solution distilled from high-purity solution manufactured by Wako Pure Chemical Industries, Ltd. was used.

By analyzing the solution after the third reprecipitation purification by high-performance liquid chromatography, it was confirmed that any material absorbing light at regions not less than 400 nm was not detected in the solution. In other words, it means that impurities were hardly contained in the solution, and the phosphorescent light emitting polymer compound was sufficiently purified. Then, the purified phosphorescent light emitting polymer compound was vacuum-dried for two days at room temperature. The phosphorescent light emitting polymer (ELP) obtained by this operation was confirmed to have the purity of over 99.9% by the high-performance liquid chromatography (detection wavelength: 254 nm).

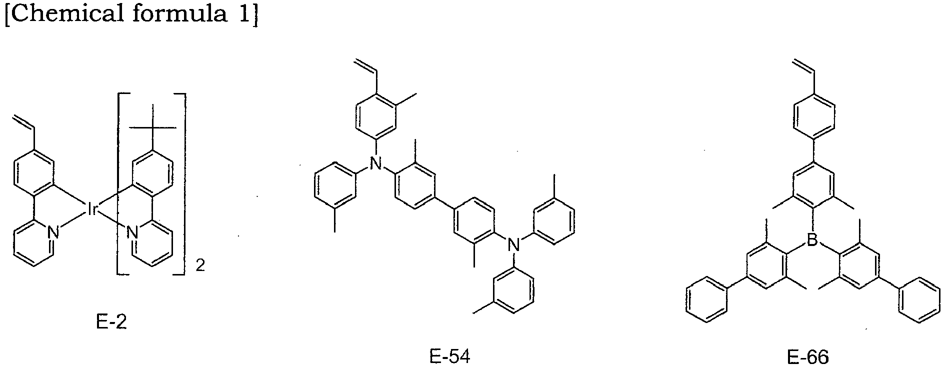

### [Preparation of light emitting material solution]

A light emitting material solution (hereinafter, also referred to as "solution A") was prepared by dissolving 3 parts by weight of the light emitting polymer compound prepared as mentioned above (weight-average molecular weight = 52,000) in 97 parts by weight of toluene.

### [Preparation of organic light emitting element]

As an organic light emitting element, the organic light emitting element 10 shown in FIG. 1 was produced by the method described below.

Specifically, first, on a glass substrate made of silica glass (25 mm per side, thickness of 1 mm), an ITO film of 150 nm in thickness was formed by using a sputtering device (E-401s manufactured by Canon ANELVA Corporation). Here, the glass substrate corresponds to the substrate 11. The ITO film corresponds to the anode layer 12.

Next, a photoresist (AZ1500 manufactured by AZ Electronic Materials) of about 1 µm in thickness was formed by a spin coating method. After ultraviolet light exposure, development was executed with 1.2% aqueous solution of TMAH (tetramethyl ammonium hydroxide: (CH₃)₄NOH) for patterning the resist layer. Thereafter, heat was applied for 10 minutes at 130 degrees C (a post-baking process).

Subsequently, dry etching using a reactive ion etching device (RIE-200iP manufactured by SAMCO Inc.) was performed to etch the ITO film. On this occasion, the etching conditions for ITO film were: using a mixed gas of Cl₂ and SiCl₄ as a reactant gas; and causing a reaction for 8 minutes under a pressure of 1 Pa and output bias/ICP = 200/100 (W).

By this dry etching, the through-holes 16c passing through the ITO film as the anode layer 12 was formed. Then the residue of the resist was removed by the resist removing solution. The through-hole 16c was in a cylinder shape with a diameter of 1 µm, which was arranged in a hexagonal lattice pattern on the anode layer 12, and distance between edges of the through-holes 16c was 1 µm.

Then, a silicon dioxide layer (SiO₂) of 120 nm in thickness was formed by using a sputtering device (E-401s manufactured by Canon ANELVA Corporation). By this process, the first dielectric layer 13 and the second dielectric layer 19 can be formed together.

Next, the glass substrate was washed by spraying pure water and dried by a spin dryer.

Then the solution A was applied by the spin coating method (spin rate: 3000 rpm), and subsequently, the glass substrate was left under a nitrogen atmosphere at the temperature of 120°C for an hour, and thus the light emitting portion 17 and the extension portion 17a were formed. It should be noted that the thickness of side surface of the light emitting portion 17 to be in contact with the side surface 12a of the anode layer 12 was 30 nm.

Then, the glass substrate was placed in a vacuum deposition chamber, and a sodium (Na) film having the thickness of 2.0 nm as the cathode buffer layer was formed on the light emitting portion 17 and the extension portion 17a by a vacuum deposition device. Subsequently, an aluminum (Al) film having the thickness of 150 nm as the cathode layer 14 was formed. The organic light emitting element 10 was able to be produced by the aforementioned processes.

### (Example 2)

The organic light emitting element 10 was produced in the same manner as example 1 except that a magnesium-fluoride layer was formed by using magnesium fluoride (MgF₂) as the material for forming the first dielectric layer 13 and the second dielectric layer 19 instead of using silicon dioxide (SiO₂). The magnesium-fluoride layer can be formed by a sputtering method similarly to a silicon dioxide layer. The thickness of the magnesium-fluoride layer was set to be 120 nm.

### (Example 3)

The organic light emitting element 10 was produced in the same manner as example 1 except that a sodium-fluoride layer was formed by using sodium fluoride (NaF) as the material for forming the first dielectric layer 13 and the second dielectric layer 19 instead of using silicon dioxide (SiO₂). The sodium-fluoride layer can be formed by a vacuum deposition. The thickness of the sodium-fluoride layer was set to be 120 nm.

### (Example 4)

The organic light emitting element 10d shown in FIG. 4 was produced as an organic light emitting element by changing the following points with respect to the Example 1.

After forming the silicon dioxide (SiO₂) layer having the thickness of 140 nm as the first dielectric layer 13 and the second dielectric layer 19, anisotropic etching was performed by using a reactive ion etching device (RIE-200iP manufactured by SAMCO Inc.). On this occasion, the etching conditions were: using CHF₃ as a reactant gas; and causing a reaction for 10 minutes under a pressure of 0.2 Pa and output bias/ICP = 120/100 (W).

Thereby, the thickness of the second dielectric layer 19 was 140 nm, which shows little change, however, the thickness of the first dielectric layer 13 was 90 nm and formed to be a thin-film. In the exemplary embodiment, the thickness of the side surface of the light emitting portion 17 to be in contact with the side surface 12a of the anode layer 12 is 10 nm. As for other conditions, processes similar to those of the Example 1 were performed.

### (Example 5)

The organic light emitting element 10e shown in FIG. 5 was produced as an organic light emitting element by changing the following points with respect to the Example 1.

After forming the silicon dioxide (SiO₂) layer having the thickness of 140 nm as the first dielectric layer 13 and the second dielectric layer 19, isotropic etching was performed by using a reactive ion etching device (RIE-200iP manufactured by SAMCO Inc.). On this occasion, the etching conditions were: using CHF₃ as a reactant gas; and causing a reaction for 15 minutes under a pressure of 0.7 Pa and output bias/ICP = 40/100 (W).

Thereby, the edge portion of the first dielectric layer 13, which was in contact with the through-hole portions 16, was etched to be tapered. Moreover, the light emitting portion 17 was in a state of being in contact with the upper surface 12b of the anode layer 12 with a width of 20 nm. As for other conditions, processes similar to those of the Example 1 were performed.

### (Example 6)

The organic light emitting element 10e shown in FIG. 5 was produced as an organic light emitting element by changing the following points with respect to the Example 1.

The first dielectric layer 13 and the second dielectric layer 19 were formed by coating method.

Specifically, silicone of coating type (OCD Type2 Si-49000-SG, manufactured by TOKYO OHKA KOGYO CO., LTD.) was diluted to 50 wt% with a solvent in which ethanol and ethyl acetate were mixed in volume with a ration of 1 to 1. Then, the coating was performed by a spin coater (spin rate of 2000 rpm for 30 seconds). Thereafter, heat treatment was performed at 300 °C for an hour. As a result, a silicone layer which was a base for the first dielectric layer 13 and the second dielectric layer 19 was formed as a continuous layer that had a thickness of 130 nm on the anode layer 12 and 160 nm at the bottom portion of the through-hole portions 16. In this state, anisotropic etching was performed. Thereby, an end portion of the first dielectric layer 13 to be in contact with the through-hole portions 16 was etched to be tapered. Furthermore, the first dielectric layer 13 and the second dielectric layer 19 were separately formed, and each thickness thereof was 100 nm and 140 nm, respectively. The light emitting portion 17 was in a state to be in contact with the side surface 12a of the anode layer 12 with a thickness of 10 nm. As for other conditions, processes similar to those of the Example 1 were performed.

### (Example 7)

The organic light emitting element 10f shown in FIG. 6 was produced as an organic light emitting element by changing the following points with respect to the Example 1.

After etching the ITO film as the anode layer 12 to form the through-hole upper part 16a, dry etching was performed by using a reactive ion etching device (RIE-200iP manufactured by SAMCO Inc.). On this occasion, the reactive conditions were: injecting an oxygen gas into the reactive ion etching device; generating an oxygen plasma by applying an AC voltage to discharge an electrical current; and radiating the plasma to a glass substrate. The flow amount of the oxygen gas injected into the plasma generating device was adjusted, and the reaction was performed under a pressure of 1 Pa and an input power of 150 W for 30 seconds. Next, a gas to be injected was changed from the oxygen gas to CHF₃ gas. Here, the flow amount of the gas was adjusted and a pressure was set to be 7 Pa. The reaction was performed in PE mode with an input power of 300 W for 10 seconds. As a result, the bored part 16b with a depth of 100 nm was formed.

Further, the silicon dioxide (SiO₂) layer as the first dielectric layer 13 and the second dielectric layer 19 was set to be 200 nm. Therefore, in the exemplary embodiment, the thickness of the side surface of the light emitting portion 17 to be in contact with the side surface 12a of the anode layer 12 was 50 nm. As for other conditions, processes similar to those of the Example 1 were performed.

### (Example 8)

The organic light emitting element 10 shown in FIG. 1 was produced as an organic light emitting element. On this occasion, the light emitting portion 17 was film-formed by a vacuum deposition method.

That is, in the Example 1, instead of coating with the solution A, a laminated structure disclosed as DEVICE II in FIG. 1 of a literature (Organic Electronics 2 (2001) P 37-43) was formed. Specifically, a substrate after cleaning was set in a vacuum deposition device, then, αNPD (manufactured by DOJINDO LABORATORIES) of 50 nm, a layer in which CBP (manufactured by DOJINDO LABORATORIES) and Ir(ppy)3 (manufactured by DOJINDO LABORATORIES) are co-evaporated to a thickness of 20 nm with a ratio of 95 to 5, and BCP (manufactured by DOJINDO LABORATORIES) of 10 nm, Alq3 (manufactured by DOJINDO LABORATORIES) of 40 nm were deposited in this order on the substrate, to form the light emitting portion 17.

It should be noted that, in the exemplary embodiment, AgMg layer (weight ratio of 25 to 1) with a thickness of 100 nm was formed as the cathode buffer layer and the cathode layer 14. As for other conditions, processes similar to those of the Example 1 were performed.

### (Example 9)

The organic light emitting element 10 shown in FIG. 1 was produced as an organic light emitting element. On this occasion, the organic light emitting element 10 was produced in the following method so that light was able to be extracted from both the lower surface (the anode layer 12 side) and the upper surface (the cathode layer 14 side).

In the Example 1, instead of forming the ITO film as the anode layer 12, a silver (Ag) layer was formed with a thickness of 150 nm on the glass substrate made of silica glass (25 mm per side, thickness of 1 mm) by using the same sputtering device. The silver layer having been formed in this manner was opaque to the visible light.

Etching conditions of the silver layer were: using Cl₂ gas as a reactant gas; and causing a reaction for 6 minutes under a pressure of 1 Pa and output bias/ICP = 200/100 (W). As a result, light was able to be extracted from an area where the silver layer was not formed.

At the occasion of forming the aluminum layer, the thickness thereof was set to be 10 nm, and ITO film was formed thereon with a thickness of 100 nm by a resistance heating deposition method. The cathode layer 14 made of the aluminum layer and the ITO film having been formed in this manner was transparent to the visible light. As for other conditions, processes similar to those of the Example 1 were performed.

### (Comparative Example 1)

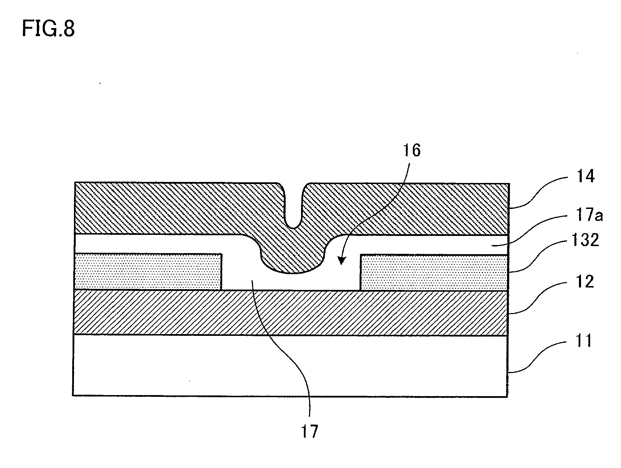

An organic light emitting element having a configuration of FIG. 8 was formed in the following method.

Specifically, first, on a glass substrate made of silica glass (25 mm per side, thickness of 1 mm), an ITO film of 150 nm in thickness- and a silicon dioxide (SiO₂) layer of 120 nm in thickness were formed by using a sputtering device (E-401s manufactured by Canon ANELVA Corporation). Here, the glass substrate corresponds to the substrate 11. The ITO film corresponds to the anode layer 12, and the silicon dioxide (SiO₂) layer corresponds to a dielectric layer 132.

Next, a photoresist (AZ1500 manufactured by AZ Electronic Materials) of about 1 µm in thickness was formed by a spin coating method. After ultraviolet light exposure, development was executed with 1.2% aqueous solution of TMAH (tetramethyl ammonium hydroxide: (CH₃)₄NOH) for patterning the resist layer. Thereafter, heat was applied for 10 minutes at 130 degrees C (a post-baking process).

Subsequently, dry etching using a reactive ion etching device (RIE-200iP manufactured by SAMCO Inc.) was performed to etch the silicon dioxide layer. On this occasion, the etching conditions for silicon dioxide layer were: using CHF₃ gas as a reactant gas; and causing a reaction for 18 minutes under a pressure of 0.3 Pa and output bias/ICP = 50/100 (W).

By this dry etching, the through-hole portions 16 passing through the silicon dioxide layer as the dielectric layer 132 were formed. Then the residue of the resist was removed by the resist removing solution. Each of the through-hole portions 16 was in a cylinder shape with a diameter of 1 µm, which was arranged in a hexagonal lattice pattern on the anode layer 12, and distance between edges of the through-hole portions 16 was 1 µm. It should be noted that the ITO film as the anode layer 12 in the Comparative Example remains as a uniform film without being etched.

Next, the glass substrate was washed by spraying pure water and dried by a spin dryer.

Then the solution A was applied by the spin coating method (spin rate: 3000 rpm), and subsequently, the glass substrate was left under a nitrogen atmosphere at the temperature of 120°C for an hour, and thus the light emitting portion 17 and the extension portion 17a were formed.

Then, the glass substrate was placed in a vacuum deposition chamber, and a sodium (Na) film having the thickness of 2.0 nm as the cathode buffer layer was formed on the light emitting portion 17 and the extension portion 17a by a vacuum deposition device. Subsequently, an aluminum (Al) film having the thickness of 150 nm as the cathode layer 14 was formed. The organic light emitting element was produced by the aforementioned processes.

### (Comparative Example 2)

An organic light emitting element having the same configuration as the organic light emitting element illustrated in the Comparative Example 1 was produced as an organic light emitting element. However, the light emitting portion 17 was formed by a vacuum deposition method illustrated in the Example 8. The material and the laminating configuration at this occasion were similar to those of the Example 8. Further, AgMg layer (weight ratio of 25 to 1) with a thickness of 100 nm was formed as the cathode buffer layer and the cathode layer 14.

### (Comparative Example 3)

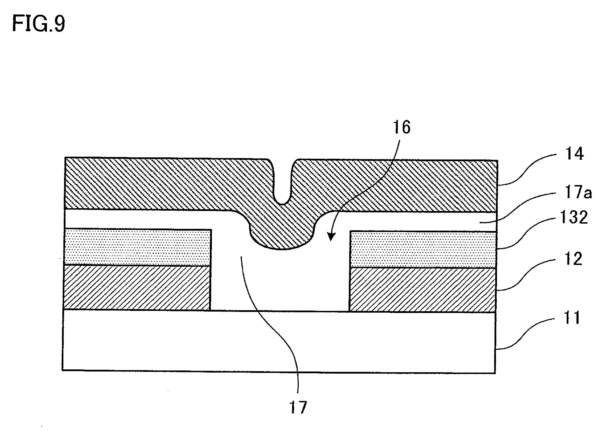

An organic light emitting element having the configuration shown in FIG. 9 was produced as an organic light emitting element by changing the following points with respect to the Comparative Example 1. After forming the ITO film as the anode layer 12, the silicon dioxide (SiO₂) layer as the dielectric layer 132 was formed with a thickness of 120 nm. Then, the dielectric layer 132 was patterned by dry etching. Thereafter, subsequently, the ITO film was etched. The etching conditions for ITO film were: using a mixed gas of Cl₂ and SiCl₄ as a reactant gas; and causing a reaction for 8 minutes under a pressure of 1 Pa and output bias/ICP = 200/100 (W). By this dry etching, the through-hole portions 16 passing through the ITO film as the anode layer 12 were formed. Then the residue of the resist was removed by the resist removing solution. Each of the through-hole portions 16 was in a cylinder shape with a diameter of 1 µm, which was arranged in a hexagonal lattice pattern on the anode layer 12, and distance between edges of the through-hole portions 16 was 1 µm.

### (Comparative Example 4)

An organic light emitting element having the same configuration as the organic light emitting element illustrated in the Comparative Example 3 was produced as an organic light emitting element. However, following points were changed with respect to the Comparative Example 3. That is, instead of forming the ITO film as the anode layer 12, a silver (Ag) layer was formed with a thickness of 150 nm by using the same sputtering device. Then a silicon dioxide (SiO₂) layer as the dielectric layer 132 of 120 nm in thickness was formed. Thereafter, the dielectric layer 132 was etched, and the silver layer was subsequently etched. Etching conditions of the silver layer were; using Cl₂ gas as a reactant gas; and causing a reaction for 6 minutes under a pressure of 1 Pa and output bias/ICP = 200/100 (W). As a result, light was able to be extracted from an area where the silver layer was not formed.

At the occasion of forming the aluminum layer, the thickness thereof was set to be 10 nm, and ITO film was formed thereon with a thickness of 100 nm by a resistance heating deposition method. The cathode layer 14 made of the aluminum layer and the ITO film having been formed in this manner was transparent to the visible light. As for other conditions, processes similar to those of the Example 3 were performed.

Voltage was gradually applied to the organic light emitting elements produced in the Examples 1 to 9 and the Comparative Examples 1 to 4 by using a constant-voltage power supply (SM2400 manufactured by Keithley Instruments, KK) to measure an emission intensity with a brightness meter (BM-9 manufactured by TOPCON CORPORATION). From the ratio of the emission intensity to the current density, the light emitting efficiency was determined. In the Example 9, however, since light was emitted from the upper surface (the cathode layer 14 side) in addition to the lower surface (the anode layer 12 side), the light emitting efficiency was set to be a sum total of measured values at the upper surface and the lower surface.

Moreover, the refractive index of the second dielectric layer 19 was measured in the case of a light with a wavelength of 550 nm.

Table 1 shows the result. It should be noted that the result of the light emitting efficiency is a numerical value normalized as that of the Comparative Example 1 to be 1.0. Regarding the Comparative Examples 1 to 4, the refractive index of the light emitting portion 17 was recorded to compare with the second dielectric layer 19. It should be noted that the refractive index of ITO was 1.75.

The evaluation results above are collectively shown in Table 1.

**[Table 1]**

| | Second dielectric layer | | Light emitting efficiency |
|---|---|---|---|
| | Material | Refractive index | |
| Example 1 | SiO₂ | 1.45 | 1.3 |
| Example 2 | MgF₂ | 1.38 | 1.4 |
| Example 3 | NaF | 1.32 | 1.45 |
| Example 4 | SiO₂ | 1.46 | 1.35 |
| Example 5 | SiO₂ | 1.46 | 1.35 |
| Example 6 | Silicone | 1.43 | 1.3 |
| Example 7 | SiO₂ | 1.46 | 1.6 |
| Example 8 | SiO₂ | 1.46 | 0.9 |
| Example 9 | SiO₂ | 1.46 | 1.1 |
| Comparative Example 1 | Not provided | 1.68 (Light emitting portion) | 1.0 |
| Comparative Example 2 | Not provided | 1.68 (Light emitting portion) | 0.7 |
| Comparative Example 3 | Not provided | 1.68 (Light emitting portion) | 1.1 |
| Comparative Example 4 | Not provided | 1.68 (Light emitting portion) | 0.8 |

Comparing the Examples 1 to 3 with the Comparative Examples 1 and 3, it is found that better light emitting efficiency is obtained in the case where the first dielectric layer 13 and the second dielectric layer 19 are formed. In addition, in the producing method shown in the Example 1, compared with the producing method shown in the Comparative Example 3, only the ITO film as the anode layer 12 is etched. Therefore, in the Example 1, it is not necessary to perform a dry etching on the second dielectric layer 19 and the anode layer 12 successively as it is in the Comparative Example 3, thus the Example 1 has an advantage of being able to stably produce an organic light emitting element. Comparing the Examples 1 to 3 with each other, the light emitting efficiency is better in the Example 2 than in the Example 1, and much better in the Example 3 than in the Example 1. This is considered to be due to difference in material forming the first dielectric layer 13 and the second dielectric layer 19. In other words, it is considered that magnesium fluoride (MgF₂) and sodium fluoride (NaF) respectively used in the Examples 2 and 3 have lower refractive index than silicon dioxide (SiO₂) used in the Example 1, and the light emitting efficiency is better in the case of using the material having lower refractive index. As in the Example 3, the light emitting efficiency is better even in the case where sodium fluoride (NaF) that is soluble in water and difficult to perform a photolithography is used, which leads to the following that the material which can be formed in a vacuum deposition method may be used.

Next, comparing the Examples 4 to 7 with the Comparative Examples 1 and 3, it is found that the light emitting efficiency is improved in each Example than in each Comparative Example. By these results, it is found that the light emitting efficiency is improved even in the case as in the Example 4 where the first dielectric layer 13 is thinner than the second dielectric layer 19. Moreover, it is found that the light emitting efficiency is improved even in the case as in the Example 5 where the light emitting portion 17 is in contact with the upper surface of the anode layer 12.

Furthermore, the light emitting efficiency is better even in the case as in the Example 6 where the first dielectric layer 13 and the second dielectric layer 19 are formed by coating method, which leads to the following that coating method can be adopted in forming the first dielectric layer 13 and the second dielectric layer 19. By adopting coating method, the advantages of; (1) there are more options of an applicable material since the material that can be formed only by the film-coating are able to be used (in other words, a material that is more inexpensive than a material formed by vacuum forming like sputtering, or a coating material having good characteristics are applicable.); and (2) film-forming by coating method is generally more inexpensive (equipment thereof is more inexpensive) than film-forming by vacuum forming such as sputtering and the like are obtained.

Comparing the Examples 1 and 7, it is found that the light emitting efficiency is better in the case where the bored part 16b is formed, and by forming the bored part 16b, the light emitting efficiency is much improved.

Furthermore, the Example 9 and the Comparative Examples 1 and 4 are compared. In the Example 9 and the Comparative Example 4, light can be extracted from both sides of the anode layer 12 and the cathode layer 14. The light emitting efficiency in the Example 9 is better than that in the Comparative Example 1, and it is found that providing the first dielectric layer 13 and the second dielectric layer 19 is effective. However, compared with the Example 1, the light emitting efficiency is lowered since the light from the cathode layer 14 side passes through the ITO film. The material and thickness of the anode layer 12 and the cathode layer 14 in the Example 9 are different from those in the Comparative Example 1, thus it is found that the light emitting efficiency is improved compared with the Comparative Example 4, which is similarly produced. By this, it may be said that providing the second dielectric layer 19 is effective even in the configuration where the electrode material are used and light is extracted from both sides as in the Example 9. Furthermore, in the Example 9, compared with the Comparative Example 4, the step between a bottom surface at the through-hole portions 16 of the light emitting portion 17, and an upper portion of the first dielectric layer 13 and the dielectric layer 132 is made smaller, thereby coverage property thereof is improved when the light emitting portion 17 and the extension portion 17a are formed. Therefore, organic light emitting elements that are less likely to be short-circuited can be formed stably.

On the other hand, the light emitting portion 17 is formed by vacuum deposition method in the Example 8 and the Comparative Example 2. From the results of the Example 8 and the Comparative Example 2, it is found that the organic light emitting element excellent in light emitting efficiency can be produced by providing the first dielectric layer 13 and the second dielectric layer 19. However, comparing the Example 8 with the Example 1, the light emitting efficiency is better in forming the light emitting portion 17 by coating method. This may be because, in the vacuum deposition method, the light emitting material is difficult to be filled in the through-hole portions 16 with a uniform thickness compared with coating method.

### Reference Signs List

- 10: Organic light emitting element
- 11: Substrate
- 12: Anode layer
- 13: First dielectric layer
- 14: Cathode layer
- 16: Through-hole portions
- 16a: Through-hole upper part
- 16b: Bored part
- 17: Light emitting portion
- 19: Second dielectric layer

## Claims

1. An organic light emitting element comprising:
a first electrode layer that is formed on a substrate;
a first dielectric layer that is formed on the first electrode layer;
a second electrode layer that is formed on the first dielectric layer;
a plurality of through-hole portions that pass through at least the first electrode layer and the first dielectric layer;
a second dielectric layer that is formed in contact with an upper surface of the substrate and a side surface of the first electrode layer in each of the through-hole portions; and
a light emitting portion that is formed in contact with the side surface of the first electrode layer, an upper surface of the second dielectric layer and the second electrode layer in each of the through-hole portions.

2. The organic light emitting element according to claim 1, wherein a thickness of the second dielectric layer on the basis of the upper surface of the substrate is thinner than a thickness of the first electrode layer.

3. The organic light emitting element according to any one of claims 1 and 2, wherein, at an upper surface of the first dielectric layer, each of the through-hole portions has a circular shape or a polygonal shape with a maximum width of 10 µm or less, or the through-hole portions are formed in a belt-like shape parallel to each other with a width of 10 µm or less.

4. The organic light emitting element according to claim 3, wherein 10³ to 10⁸ of the through-hole portions having the circular shape or the polygonal shape are formed per arbitrary 1 mm square plane of the first dielectric layer.

5. The organic light emitting element according to claim 3, wherein an interval between each of the through-hole portions with the belt-like shape is 10 µm or less.

6. The organic light emitting element according to any one of claims 1 to 5, wherein the second dielectric layer is composed of a material which is transparent to the visible light in the range of 400 nm to 750 nm.

7. The organic light emitting element according to any one of claims 1 to 6, wherein both a refractive index of the first dielectric layer and a refractive index of the second dielectric layer are smaller than a refractive index of the first electrode layer.

8. The organic light emitting element according to any one of claims 1 to 7, wherein a refractive index of the first dielectric layer is smaller than a refractive index of the light emitting portion.

9. The organic light emitting element according to any one of claims 1 to 8, wherein a thickness of the first dielectric layer is thinner than a thickness of the second dielectric layer.

10. The organic light emitting element according to any one of claims 1 to 9, wherein each of the through-hole portions comprises;
a through-hole upper part that is formed to pass through at least the first electrode layer and the first dielectric layer; and
a bored part that is formed in the substrate.

11. A method for manufacturing an organic light emitting element comprising:
a first process in which a first electrode layer is formed on a substrate;
a second process in which a plurality of through-holes passing through the first electrode layer are formed;
a third process in which a plurality of through-hole portions that include the through-holes and pass through the first electrode layer and a first dielectric layer are formed by forming the first dielectric layer on the first electrode layer and by forming a second dielectric layer to contact with an upper surface of the substrate and a side surface of the first electrode layer exposed to an inside of the through-holes;
a fourth process in which a light emitting portion is formed to contact with the side surface of the first electrode layer exposed to an inside of the through-hole portions and an upper surface of the second electrode layer; and
a fifth process in which a second electrode layer is formed to cover an upper part of the first dielectric layer and an upper part of the light emitting portion and to contact with the light emitting portion.

12. The method for manufacturing an organic light emitting element according to claim 11, further comprising a film thinning process in which a thickness of the first dielectric layer is made thin, between the third process and the fourth process.

13. The method for manufacturing an organic light emitting element according to any one of claims 11 and 12, further comprising a process in which a part of the first electrode layer covered with the first dielectric layer and/or the second dielectric layer is exposed, between the third process and the fourth process.

14. The method for manufacturing an organic light emitting element according to any one of claims 11 to 12, wherein, in the second process, a bored part is further formed in the substrate at a bottom portion of each of the through-holes.

15. A method for manufacturing an organic light emitting element comprising:
a first process in which a first electrode layer is formed on a substrate;
a second process in which a first dielectric layer is formed on the first electrode layer;
a third process in which a plurality of through-hole portions to pass through at least the first electrode layer and the first dielectric layer are formed;
a fourth process in which, in the through-hole portions, a second dielectric layer is formed to contact with an upper surface of the substrate and a side surface of the first electrode layer exposed to an inside of the through-hole portions;
a fifth process in which a light emitting portion is formed to contact with the side surface of the first electrode layer exposed to an inside of the through-hole portions and an upper surface of the second dielectric layer; and
a sixth process in which a second electrode layer is formed to cover an upper part of the first dielectric layer and an upper part of the light emitting portion and to contact with the light emitting portion.

16. The method for manufacturing an organic light emitting element according to claim 15, further comprising a process in which a part of the first electrode layer covered with the first dielectric layer and/or the second dielectric layer is exposed, between the fourth process and the fifth process.

17. The method for manufacturing an organic light emitting element according to any one of claims 15 and 16, wherein, in the second process, a bored part is further formed in the substrate at a bottom portion of each of the through-hole portions.
